# EUROPÄISCHE PATENTSCHRIFT

(11) **EP 3 174 657 B1**
(45) Veröffentlichungstag und Bekanntmachung des Hinweises auf die Patenterteilung: **14.07.2021**
(21) Anmeldenummer: 15716083.9
(22) Anmeldetag: 17.04.2015
(51) Int. Cl.: B22F 5/00, B22F 7/04, H01L 23/00, H05K 3/32, B23K 35/02, B23K 35/30, H05K 1/09

(54) **VERFAHREN ZUR HERSTELLUNG EINES SILBERSINTERMITTELS MIT SILBEROXIDOBERFLÄCHEN UND SEINE VERWENDUNG IN VERFAHREN ZUM VERBINDEN VON BAUELEMENTEN DURCH DRUCKSINTERN**
METHOD OF MAKING A METALLIC SINTERING MATERIAL WITH METAL OXIDE SURFACES AND USE OF SAME IN METHODS FOR JOINING STRUCTURAL ELEMENTS BY MEANS OF PRESSURE SINTERING
PROCÉDÉ DE FABRICATION D'UN AGENT DE FRITTAGE MÉTALLIQUE À COUCHES D'OXYDE MÉTALLIQUE ET SON UTILISATION DANS LE PROCÉDÉ DE LIAISON DE COMPOSANTS PAR FRITTAGE SOUS PRESSION

(30) Priorität: 28.07.2014 EP 14178758
(43) Veröffentlichungstag der Anmeldung: 07.06.2017
(73) Patentinhaber: Heraeus Deutschland GmbH & Co. KG, 63450 Hanau (DE)
(72) Erfinder: SCHÄFER, Michael, 36093 Künzell (DE); SCHMITT, Wolfgang, 63110 Rodgau (DE)
(74) Vertreter: Heraeus IP
(86) Internationale Anmeldenummer: PCT/EP2015/058441
(87) Internationale Veröffentlichungsnummer: WO 2016/015880

(56) Entgegenhaltungen:
- EP-A2- 0 579 911
- EP-A2- 2 428 293
- US-A1- 2008 160 183
- US-A1- 2010 195 292
- None

## Beschreibung

Die Erfindung betrifft ein Verfahren zur Herstellung eines Silbersintermittels mit Silberoxidoberflächen und seine Verwendung in Verfahren zum Verbinden von Bauelementen durch Drucksintern.

Bei den hierin erwähnten Metalloxid- und Silberoxidoberflächen oder Metalloxid- und Silberoxidschichten handelt es sich jeweils um äußere oder nach außen weisende Metalloxid- und Silberoxidoberflächen bzw. Metalloxid- und Silberoxidschichten. Bezüglich des Silbersintermittels kann es sich insbesondere auch um eine dessen gesamte äußere Oberfläche bedeckende und insofern nach außen weisende Silberoxidoberfläche oder Silberoxidschicht handeln.

US 2010/0195292 A1 offenbart Elektronikbauteile mit einer Silberelektrode, die mit einer äußeren Silberoxidschicht versehen ist. Die Silberoxidschicht kann zur direkten Sinteranbindung des Elektronikbauteils an eine damit zu verbindende Oberfläche genutzt werden, wobei das Silberoxid zu Silber reduziert wird.

US 2008/160183 A1 offenbart ein Sinterverbindungsverfahren, bei dem eine zu einer leitfähigen Schicht sinterfähige Zusammensetzung, die organisch gecoatete Silberpartikel und Silberoxidpartikel umfasst, zur Herstellung einer Sinterverbindung zwischen zu verbindenden Oberflächen verwendet wird. Die noch sinterfähige Zusammensetzung kann die Anwendungsform einer Tinte, einer Paste oder einer Sintervorform in Form eines schichtförmigen Presslings besitzen.

EP 0 579 911 A2 offenbart ein Verfahren zur Herstellung schlickergegossener isotroper Verbundwerkstoffe auf Kupferbasis. Dabei wird ein Mischschlicker auf ein geeignetes Substrat vergossen, ausgebrannt, gesintert und über Kaltwalz- und Anlassschritte zu einem massiven Band verarbeitet. Die Verbundwerkstoffe können zur Herstellung elektronischer Bauteile verwendet werden.

In der Elektronikindustrie ist die Verwendung von Metall- bzw. Silbersinterpasten oder von daraus durch Applikation und Trocknung hergestellten noch sinterfähigen (sinterbaren) Sintervorformen (sogenannte sinter preforms) zur Befestigung und elektrischen Kontaktierung von und zur Wärmeabfuhr aus Elektronikbauteilen wie beispielsweise Halbleiterchips bekannt. So sind solche Metall- bzw. Silbersinterpasten und Sintervorformen beispielsweise am 17. Januar 2014 in der online-Publikation "Are Sintered Silver Joints Ready for Use as Interconnect Material in Microelectronic Packaging?" des Autors KIM S. SIOW im Journal of ELECTRONIC MATERIALS (DOI: 10.1007/s11664-013-2967-3) beschrieben. Beispiele für Patentliteratur zu Metall- bzw. Silbersinterpasten sind WO2011/026623A1, EP2425920A1, EP2428293A1 und EP2572814A1. Üblicherweise werden solche Metall- bzw. Silbersinterpasten durch Drucken, beispielsweise Sieb- oder Schablonendruck, auf Trägersubstrate aufgebracht, gegebenenfalls getrocknet, mit Elektronikbauteilen bestückt und dann einem Sintervorgang unterworfen. Ohne den flüssigen Zustand zu durchlaufen, verbinden sich die Metall- bzw. Silberteilchen während des Sinterns durch Diffusion unter Ausbildung einer festen, elektrischen Strom und Wärme leitenden metallischen bzw. Silber-Verbindung zwischen Träger und Elektronikbauteil.

Wie von der Anmelderin festgestellt werden konnte, kann eine Befestigung zwischen Bauelementen unter Ausbildung einer Sinterverbindung allerdings auch ohne oder ohne direkte Verwendung einer Metall- bzw. Silbersinterpaste erzielt werden. Anstelle einer Metall- bzw. Silbersinterpaste kann überraschenderweise ein nach dem in der Folge näher erläuterten erfindungsgemäßen Verfahren hergestelltes Silbersintermittel in Form eines schichtförmigen Silbersinterkörpers mit Silberoxidoberflächen verwendet werden.

Bei dem nach dem erfindungsgemäßen Verfahren hergestellten Silbersintermittel handelt es sich um einen schichtförmigen Silbersinterkörper mit Silberoxidoberflächen, d.h. mit einer Gesamtoberfläche oder mehreren diskreten Oberflächen jeweils in Form einer Silberoxidschicht. Es handelt sich bei dem Silbersintermittel also um einen diskreten, d.h. frei bzw. als einzelnes separates Teil vorliegenden schichtförmigen Silbersinterkörper, also eine diskrete bzw. freie gesinterte Silberschicht, welche besagte Silberoxidoberflächen aufweist. Die Dicke oder Schichtstärke des schichtförmigen Silbersinterkörpers liegt beispielsweise im Bereich von 10 bis 300 µm.

Das Silber des Silbersintermittels kann reines Silber oder eine Silberlegierung sein. Die Legierungen weisen beispielsweise einen Anteil von > 50 Gew.-% Silber auf.

Wie schon gesagt, handelt es sich bei dem nach dem erfindungsgemäßen Verfahren hergestellten Silbersintermittel um einen schichtförmigen Silbersinterkörper, d.h. um eine gesinterte Silberstruktur in Form einer Schicht, mit anderen Worten, um eine als solche nicht mehr sinterfähige Silberstruktur. Eine solche gesinterte Silberstruktur umfasst außer den schon genannten äußeren Silberoxidoberflächen insbesondere kein Silberoxid, also kein Silberoxid in der Masse. Ein solcher schichtförmiger Silbersinterkörper ist nicht zu verwechseln mit einer der eingangs genannten noch sinterfähigen Sintervorformen.

Das Silbersintermittel in Gestalt des schichtförmigen Silbersinterkörpers mit Silberoxidoberflächen (in der weiteren Folge auch kurz "Silbersintermittel" oder "schichtförmiges Silbersintermittel" genannt) kann gemäß dem erfindungsgemäßen Verfahren durch (1) Applikation, beispielsweise mittels Siebdruck, Schablonendruck oder Sprühauftrag aus einer Silbersinterzubereitung auf ein Trägersubstrat mit einer zur Ausbildung einer Sinterverbindung unfähigen Oberfläche, (2) anschliessendes Sintern der applizierten Silbersinterzubereitung mit oder bevorzugt ohne Anwendung von mechanischem Druck, gefolgt von (3) Ablösen des so gebildeten schichtförmigen Silbersinterkörpers von der Oberfläche des Trägersubstrats hergestellt werden. Falls nach dieser Herstellungsabfolge keine oder eine nur unzureichende Silberoxidschicht auf der Oberfläche des schichtförmigen Silbersinterkörpers, beispielsweise durch Luftoxidation, entstanden ist, kann (4) ein nachgeschalteter Oxidationsschritt zwecks Herstellung oder Verstärkung einer Silberoxidschicht auf der gesamten oder auf Teilen der äußeren Oberfläche des schichtförmigen Silbersinterkörpers angeschlossen werden. Dabei können die Oxidationsverfahren angewendet werden, wie sie in der weiteren Folge noch erläutert werden.

Demgemäß umfasst das erfindungsgemäße Verfahren zur Herstellung des Silbersintermittels in Form eines schichtförmigen Silbersinterkörpers mit Silberoxidoberflächen die Schritte:
(1) Applizieren einer Silbersinterzubereitung auf ein Trägersubstrat mit einer zur Ausbildung einer Sinterverbindung unfähigen Oberfläche,
(2) Sintern der so applizierten Silbersinterzubereitung,
(3) Ablösen des in Schritt (2) gebildeten schichtförmigen Silbersinterkörpers von der Oberfläche des Trägersubstrats, sowie
(4) gegebenenfalls Herstellen oder Verstärken einer Silberoxidschicht auf der gesamten oder auf Teilen der äußeren Oberfläche des schichtförmigen Silbersinterkörpers im Zuge eines Schritt (3) nachgeschalteten Oxidationsschritts.

Beispiele für bei der Herstellung eines solchen schichtförmigen Silbersinterkörpers verwendbare Silbersinterzubereitungen sind die eingangs schon erwähnten Silbersinterpasten.

Als bei der Herstellung der schichtförmigen Silbersinterkörper verwendbare Trägersubstrate mit einer zur Ausbildung einer Sinterverbindung unfähigen Oberfläche eignen sich beispielsweise Aluminiumoxidkeramiken, Nickelbleche, Polyimidfolien, Polytetrafluorethylenfolien und Silikonfolien. Für den Fachmann ist es dabei selbstverständlich, dass er - unabhängig von der Materialauswahl - ebene Trägersubstrate mit nichtporöser und hinreichend glatter Oberfläche auswählt.

Die Applikation der Silbersinterzubereitung, beispielsweise Siebdruck, Schablonendruck oder Sprühauftrag, sowie die Durchführung des Sinterns sind dem Fachmann bekannt, es bestehen keine methodische Besonderheiten, so dass auf eine detaillierte Beschreibung verzichtet werden kann und beispielhaft auf die eingangs schon genannte Literatur verwiesen wird. Auch das Ablösen vom Trägersubstrat mit zur Ausbildung einer Sinterverbindung unfähigen Oberfläche birgt keine Schwierigkeiten, da es während des Sintervorgangs praktisch zu einer Enthaftung des gebildeten schichtförmigen Silbersinterkörpers kommt.

Es ist möglich, das Silbersintermittel im vom Verwender, beispielsweise einem Betreiber eines Verfahrens zum Verbinden von Bauelementen durch Drucksintern, gewünschten Format herzustellen, so dass beim Verwender kein Abfall in Form von Verschnitt entsteht. Ebenso kann es zweckmäßig sein, das Silbersintermittel als Endlosware herzustellen und beispielsweise noch auf dem Trägersubstrat befindlich oder schon davon abgelöst an den Verwender zu liefern. Im Falle von Endlosware kann selbige mit Sollbruchstellen, beispielsweise mit Perforationen versehen sein, um beim Verwender einfach und maßgerecht verwendet werden zu können. Im Falle von Endlosware ist Rollenware die bevorzugte Lieferform.

In jedem Falle weist das Silbersintermittel besagte Silberoxidoberflächen auf, die mit den metallischen Kontaktoberflächen der Bauelemente jeweils eine gemeinsame Kontaktfläche bilden können. Dabei können die mit den metallischen Kontaktoberflächen der Bauelemente zur Bildung gemeinsamer Kontaktflächen fähigen Silberoxidoberflächen als diskrete, d.h. voneinander abgegrenzte Silberoxidoberflächen vorliegen.

Sie können aber auch in Form einer kontinuierlichen Silberoxidschicht, die einen Teil der oder die gesamte Oberfläche des Silbersintermittels bedeckt, vorliegen.

Die Silberoxidoberflächen des Silbersintermittels befinden sich vorzugsweise auf dessen Vorder- und Rückseite, so dass die bei der Verwendung in einem Verfahren zum Verbinden von Bauelementen durch Drucksintern hergestellte Anordnung eine Sandwichstruktur hat, d.h. die Bauelemente einer Anordnung aus den Bauelementen mit dazwischen angeordnetem Silbersintermittel befinden sich dann auf einander gegenüber liegenden Seiten des Silbersintermittels.

Die äußere oder nach außen weisende Silberoxidschicht des Silbersintermittels ist fest mit dem darunter befindlichen Silber verbunden. Die Silberoxidschicht kann beispielsweise 0,02 bis 6 µm dick sein. Sie kann durch Oxidation bei Luftkontakt gebildet oder chemisch mittels Oxidationsmitteln oder durch anodische Oxidation der nicht, noch nicht, gering oder mehr oder minder stark oxidierten Silberoberfläche hergestellt oder verstärkt werden. Wie im vorhergehenden Satz schon angedeutet, kann eine schon vorhandene dünne Schicht des Silberoxids beispielsweise mittels anodischer Oxidation erzeugt oder verstärkt werden. Beispielsweise kann eine nicht, teilweise oder anoxidierte Silberoberfläche anodisch oxidiert werden bis zur Ausbildung einer Silberoxidschichtdicke von beispielsweise 0,03 bis 5 µm. Im Falle einer Silberoberfläche kann eine Silberoxidschicht mit einer Schichtdicke von beispielsweise 0,05 bis 1 µm durch anodische Oxidation ausgebildet werden.

Die anodische Oxidation kann beispielsweise durch Eintauchen des als Anode geschalteten und an bzw. auf der Oberfläche zu oxidierenden Silbersintermittels in eine geeignete wässrige Elektrolytlösung durchgeführt werden. Als wässrige Elektrolytlösungen eignen sich beispielsweise wässrige 5 bis 10 gew.-%ige Lösungen von Natriumcarbonat, Natriumhydrogencarbonat, Kaliumhydroxid oder Natriumhydroxid. Die anodische Oxidation kann beispielsweise für 5 bis 30 Sekunden bei einer Gleichspannung im Bereich von 5 bis 20 Volt durchgeführt werden.

Die Erfindung betrifft auch die Verwendung eines nach dem erfindungsgemäßen Verfahren hergestellten Silbersintermittels in einem Verfahren zum Verbinden von Bauelementen, bei dem man eine Anordnung aus wenigstens zwei jeweils eine metallische Kontaktoberfläche aufweisenden Bauelementen und dem zwischen den Bauelementen angeordneten Silbersintermittel bereitstellt und die Anordnung drucksintert, wobei Silberoxidoberflächen des Silbersintermittels mit den metallischen Kontaktoberflächen der Bauelemente jeweils eine gemeinsame Kontaktfläche bilden, und wobei (I) das Drucksintern in einer mindestens eine oxidierbare Verbindung enthaltenden Atmosphäre durchgeführt und/oder (II) die Silberoxidoberflächen vor Bildung der jeweiligen gemeinsamen Kontaktfläche mit mindestens einer oxidierbaren organischen Verbindung versehen werden.

Der hier verwendete Wortlaut "wobei Silberoxidoberflächen des Silbersintermittels mit den metallischen Kontaktoberflächen der Bauelemente jeweils eine gemeinsame Kontaktfläche bilden" soll ausdrücklich auch die Fälle einschließen, in denen nur Flächenanteile der Silberoxidoberflächen des Silbersintermittels eine gemeinsame Kontaktfläche mit den metallischen Kontaktoberflächen der Bauelemente bilden.

Das Verfahren in der Ausführungsform (I) umfasst demgemäß die Schritte:
(i) Bereitstellen wenigstens zweier Bauelemente jeweils mit metallischer Kontaktoberfläche und des Silbersintermittels in Form des schichtförmigen Silbersinterkörpers mit Silberoxidoberflächen,
(ii) Bereitstellen einer Anordnung aus den wenigstens zwei Bauelementen und dem dazwischen angeordneten Silbersintermittel unter Bildung jeweils gemeinsamer Kontaktflächen aus der jeweiligen Silberoxidoberfläche des Silbersintermittels und der metallischen Kontaktoberfläche des jeweiligen Bauelements, und
(iii) Drucksintern der Anordnung in einer mindestens eine oxidierbare Verbindung enthaltenden Atmosphäre.

Das Verfahren in der Ausführungsform (II) umfasst hingegen die Schritte:
(i) Bereitstellen wenigstens zweier Bauelemente jeweils mit metallischer Kontaktoberfläche und des Silbersintermittels in Form des schichtförmigen Silbersinterkörpers mit Silberoxidoberflächen,
(ii) Versehen der Silberoxidoberflächen mit mindestens einer oxidierbaren organischen Verbindung,
(iii) Bereitstellen einer Anordnung aus den wenigstens zwei Bauelementen und dem dazwischen angeordneten Silbersintermittel unter Bildung jeweils gemeinsamer Kontaktflächen aus der jeweiligen mit der mindestens einen oxidierbaren organischen Verbindung versehenen Silberoxidoberfläche des Silbersintermittels und der metallischen Kontaktoberfläche des jeweiligen Bauelements, und
(iv) Drucksintern der Anordnung.

Es ist möglich, die Ausführungsformen (I) und (II) zu kombinieren.

Bei beiden Ausführungsformen (I) und (II) des Verfahrens werden wenigstens zwei Bauelemente verbunden. Dabei wird eine Anordnung aus wenigstens zwei jeweils eine metallische Kontaktoberfläche aufweisenden Bauelementen und zwischen den Bauelementen angeordnetem Silbersintermittel in Form des schichtförmigen Silbersinterkörpers mit Silberoxidoberflächen bereitgestellt und diese Anordnung in üblicher, dem Fachmann bekannter Weise unter Anwendung von mechanischem Druck und erhöhter Temperatur gesintert.

Unter dem Verbinden von wenigstens zwei Bauelementen wird das Befestigen von einem ersten Bauelement auf einem zweiten Bauelement verstanden. Im Rahmen der vorliegenden Erfindung bedeutet "auf" lediglich, dass eine metallische Kontaktoberfläche des ersten Bauelements mit einer metallischen Kontaktoberfläche des zweiten Bauelements über das Silbersintermittel verbunden wird, wobei es auf die relative Lage der Bauelemente oder der Anordnung, die die Bauelemente umfasst, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden. Demgemäß kann es sich bei den Bauelementen beispielsweise um aktive Bauelemente (z.B. Halbleiterchips wie LEDs, Dioden, IGBTs, Thyristoren, MOSFETs, Transistoren, ICs), passive Bauteile (z.B. DCBs, Leadframes, Widerstände, Kondensatoren, Spulen, Induktivitäten, Memristoren, Clips, Kühlkörper), Piezokeramiken und Peltierelemente handeln.

Die zu verbindenden Bauelemente können gleichartige oder verschiedenartige Bauelemente sein.

Die Bauelemente haben jeweils eine metallische Kontaktoberfläche, wobei das Metall der metallischen Kontaktoberfläche ein reines Metall oder eine Metalllegierung sein kann. Die Legierungen weisen beispielsweise einen Anteil von > 50 Gew.-% des betreffenden Metalls auf.

Die Metalle der metallischen Kontaktoberflächen der zu verbindenden Bauelemente können gleich oder verschieden sein. Bevorzugt werden sie ausgewählt aus der aus Silber, Kupfer, Palladium und Legierungen dieser Metalle bestehenden Gruppe. Silber und Silberlegierungen sind besonders bevorzugt als Metall der metallischen Kontaktoberflächen.

Das oder die Bauelemente können aus Metall bestehen oder ihre metallische Kontaktoberfläche kann beispielsweise in Form einer Metallisierung vorliegen. Beispielsweise kann es sich um eine durch Aufdampfen, chemische Galvanisierung, Elektrogalvanisierung oder durch Applikation aus einer Metallsinterzubereitung mit anschließendem Sintern hergestellte Metallisierung handeln. Beispiele für Metallsinterzubereitungen sind die eingangs schon erwähnten Metall- oder Silbersinterpasten.

Im Falle eines nicht ohnehin aus dem Metall bestehenden Bauelementes kann die metallische Kontaktoberfläche beispielsweise 100 nm bis 200 µm dick sein.

Wie das Silbersintermittel, so können auch die metallischen Kontaktoberflächen eines der oder aller zu verbindenden Bauelemente eine Metalloxidschicht aufweisen. Bei dem Metalloxid einer solchen Metalloxidschicht kann es sich insbesondere um ein Oxid des Metalls der betreffenden metallischen Kontaktoberfläche handeln.

Die Bauelemente werden durch Drucksintern mittels des dazwischen angeordneten Silbersintermittels miteinander verbunden, d.h. die Bauelemente und das dazwischen befindliche Silbersintermittel werden durch Erhitzen und unter Anwendung mechanischen Drucks, ohne dass die Metalle der metallischen Kontaktoberflächen der Bauelemente sowie des Silbers des Silbersintermittels die flüssige Phase erreichen, miteinander verbunden.

In Ausführungsform (I) des Verfahrens findet das Drucksintern in einer mindestens eine oxidierbare Verbindung enthaltenden Atmosphäre statt. Beispiele für geeignete oxidierbare Verbindungen sind Kohlenmonoxid, Wasserstoff und Ameisensäure. Die Atmosphäre kann aus der mindestens einen oxidierbaren und gasförmig vorliegenden Verbindung bestehen oder letztere in Kombination mit inerten Gasen wie insbesondere Stickstoff und/oder Argon enthalten. Bevorzugt beträgt der Anteil an oxidierbaren Verbindungen in der Atmosphäre 1 bis 30 Volumen-%.

In Ausführungsform (II) des Verfahrens werden die Silberoxidoberflächen des Silbersintermittels und - falls die metallische Kontaktoberfläche wenigstens eines der mindestens zwei Bauelemente eine Metalloxidschicht aufweist - bevorzugt auch letztere vor Bildung der gemeinsamen Kontaktfläche mit mindestens einer, d.h. mit einer oder einer Mischung zweier oder mehrerer oxidierbarer organischer Verbindungen versehen.

Die oxidierbaren organischen Verbindungen weisen bevorzugt 1 bis 50, mehr bevorzugt 2 bis 24, noch mehr bevorzugt 6 bis 24 und noch mehr bevorzugt 8 bis 20 Kohlenstoffatome auf und haben wenigstens eine funktionelle Gruppe.

Vorzugsweise kommen als oxidierbare organische Verbindungen freie Fettsäuren, Fettsäuresalze oder Fettsäureester zum Einsatz. Die freien Fettsäuren, Fettsäuresalze und Fettsäureester sind vorzugsweise unverzweigt. Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 8 bis 18 Kohlenstoffatomen.

Bevorzugte oxidierbare organische Verbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte oxidierbare organische Verbindungen sind Dodecansäure, Octadecansäure, Aluminiumstearat, Kupferstearat, Natriumstearat, Kaliumstearat, Natriumpalmitat und Kaliumpalmitat.

Um die jeweilige Metalloxid- bzw. Silberoxidschicht mit der mindestens einen oxidierbaren organischen Verbindung zu versehen, kann letztere beispielsweise unverdünnt als Wirksubstanz oder aus einer wässrigen Zubereitung oder aus einer Zubereitung in organischem Lösemittel auf die Oberfläche der Metalloxid- bzw. Silberoxidschicht aufgetragen werden, gefolgt von einer Trocknung beispielsweise bei einer Objekttemperatur von 15 bis 50 °C während einer Trocknungsdauer von 10 bis 60 Minuten. Hinsichtlich der Auftragsart gibt es keine prinzipielle Beschränkung; beispielsweise kann die Metalloxid- bzw. Silberoxidschicht in die Zubereitung der mindestens einen oxidierbaren organischen Verbindung eingetaucht werden oder die Zubereitung der mindestens einen oxidierbaren organischen Verbindung kann auf die Metalloxid- bzw. Silberoxidschicht aufgesprüht oder aufgepinselt werden. Bei der wässrigen Zubereitung oder der Zubereitung auf Basis organischen Lösemittels kann es sich um eine beispielsweise 1 bis 20 gew.-%ige Lösung, Dispersion oder Suspension der mindestens einen oxidierbaren organischen Verbindung handeln.

Das Verhältnis der Masse der mindestens einen oxidierbaren organischen Verbindung zur Fläche der mit der mindestens einen oxidierbaren organischen Verbindung zu versehenden bzw. versehenen Silberoxidschicht beträgt beispielsweise 0,0005 bis 10 g der mindestens einen oxidierbaren organischen Verbindung pro Quadratmeter Silberoxidfläche. Der Fachmann wird dieses Verhältnis angelehnt an die Silberoxidschichtdicke wählen, d.h. je höher die Silberoxidschichtdicke ist, je höher wird er das Verhältnis der Masse der mindestens einen oxidierbaren organischen Verbindung zur Fläche der mit der mindestens einen oxidierbaren organischen Verbindung zu versehenden Silberoxidschicht wählen.

Zwecks Herstellung der gemeinsamen Kontaktflächen werden die Bauelemente jeweils mit ihrer metallischen Kontaktoberfläche auf die betreffenden mit der mindestens einen oxidierbaren organischen Verbindung versehenen Silberoxidoberflächen des Silbersintermittels aufgesetzt. Der Überlappungsbereich der metallischen Kontaktoberflächen oder Flächenanteile derselben mit der betreffenden Silberoxidoberfläche definiert dabei die gemeinsame Kontaktfläche.

Die Anordnung aus den wenigstens zwei Bauelementen mit dem dazwischen befindlichen Silbersintermittel, welches die mit der wenigstens einen oxidierbaren organischen Verbindung versehenen Silberoxidoberflächen aufweist, wird schließlich einem Drucksinterprozess unterworfen.

Das eigentliche Drucksintern erfolgt bei einer Objekttemperatur von beispielsweise 200 bis 280 °C und der Prozessdruck liegt beispielsweise im Bereich von 1 bis unter 40 MPa, bevorzugt 5 bis 20 MPa. Die Sinterzeit liegt beispielsweise im Bereich von 1 bis 5 Minuten.

Falls ausschließlich gemäß der Ausführungsform (II) des Verfahrens gearbeitet wird, kann das Drucksintern in einer Atmosphäre erfolgen, die keinen besonderen Beschränkungen unterliegt, mit Ausnahme dessen, dass sie verschieden von der bei Ausführungsform (I) vorherrschenden Atmosphäre ist. Beispielsweise kann bei der Ausführungsform (II) eine Atmosphäre vorherrschen, die Sauerstoff enthält, oder es handelt sich um eine sauerstofffreie Atmosphäre. Unter sauerstofffreier Atmosphäre ist im Rahmen der Erfindung eine Atmosphäre, insbesondere eine Inertgasatmosphäre beispielsweise aus Stickstoff und/oder Argon, zu verstehen, deren Sauerstoffgehalt nicht mehr als 500 ppm, vorzugsweise nicht mehr als 10 ppm und noch mehr bevorzugt nicht mehr als 1 ppm beträgt.

Das Drucksintern wird in einer herkömmlichen, zum Drucksintern geeigneten Vorrichtung durchgeführt, in der sich die vorstehend beschriebenen Prozessparameter einstellen lassen.

### Ausführunas- und Anwendungsbeispiel 1

Auf ein Trägersubstrat in Form einer Polytetrafluorethylenfolie wurde eine 10 x 10 mm² große Schicht aus einer Silbersinterpaste (ASP 043-04P2 von Heraeus Materials Technology) in einer Nassschichtdicke von 100 µm mittels Schablonendruck aufgebracht und danach 30 min im Umlufttrockenschrank bei 250 °C Objekttemperatur gesintert.

Das gesinterte Produkt wurde vorsichtig unter Zuhilfenahme einer Saugpipette vom Trägersubstrat abgelöst; man erhielt einen freien schichtförmigen Silbersinterkörper.

In einem Edelstahlgefäß wurde eine 10 gew.-%ige wässrige Lösung von Natriumcarbonat vorgelegt und das Edelstahlgefäß mit der Kathode einer 10 V-Gleichspannungsquelle verbunden. Die Anode der Spannungsquelle wurde mit dem freien schichtförmigen Silbersinterkörper verbunden und letzterer für 30 Sekunden in die Natriumcarbonatlösung eingetaucht.

Nach dem Austauchen wurde die infolge anodischer Oxidation schwarz verfärbte Oberfläche des freien schichtförmigen Silbersinterkörpers mit deionisiertem Wasser gespült und getrocknet. Anschliessend wurde ein Tropfen einer 2 gew.-%igen Laurinsäurelösung in Exxsol™ D60 auf die vorder- und rückseitigen Silberoxid-Oberflächen gegeben, gleichmäßig verteilt und bei 70 °C im Umlufttrockenschrank getrocknet. Danach wurde der so mit Laurinsäure versehene Silbersinterkörper zwischen die Goldoberfläche eines entsprechenden DCB-Substrates und die Silberkontaktfläche eines 10 x 10 mm² großen IGBT gefügt und die so geschaffene Sandwichanordnung für 120 Sekunden bei 250 °C Objekttemperatur und einem mechanischen Druck von 20 MPa in einer Sinterpresse gesintert.

Nach dem Sintern wurde die Haftung über die Scherfestigkeit bestimmt. Dabei wurden die Bauelemente mit einem Schermeißel bei einer Geschwindigkeit von 0,3 mm/s bei 20 °C abgeschert. Die Kraft wurde mittels einer Kraftmessdose aufgenommen (Gerät DAGE 2000 der Firma DA-GE, Deutschland). Tabelle 1 zeigt das mit Beispiel 1 erhaltene Ergebnis.

**Tabelle 1**

| Beispiel | 1 |
|---|---|
| Scherfestigkeit (N/mm²) | 31 |

## Patentansprüche

1. Verfahren zur Herstellung eines Silbersintermittels in Form eines schichtförmigen Silbersinterkörpers mit Silberoxidoberflächen, umfassend die Schritte:
(1) Applizieren einer Silbersinterzubereitung auf ein Trägersubstrat mit einer zur Ausbildung einer Sinterverbindung unfähigen Oberfläche,
(2) Sintern der so applizierten Silbersinterzubereitung,
(3) Ablösen des in Schritt (2) gebildeten schichtförmigen Silbersinterkörpers von der Oberfläche des Trägersubstrats, sowie
(4) gegebenenfalls Herstellen oder Verstärken einer Silberoxidschicht auf der gesamten oder auf Teilen der äußeren Oberfläche des schichtförmigen Silbersinterkörpers im Zuge eines Schritt (3) nachgeschalteten Oxidationsschritts.

2. Verfahren nach Anspruch 1,
wobei der schichtförmige Silbersinterkörper eine Schichtstärke im Bereich von 10 bis 300 µm hat.

3. Verfahren nach Anspruch 1 oder 2,
wobei das Trägersubstrat mit einer zur Ausbildung einer Sinterverbindung unfähigen Oberfläche ausgewählt ist aus der aus Aluminiumoxidkeramiken, Nickelblechen, Polyimidfolien, Polytetrafluorethylenfolien und Silikonfolien bestehenden Gruppe.

4. Verfahren nach einem der vorhergehenden Ansprüche,
wobei das Silbersintermittel als Endlosware vorliegt.

5. Verfahren nach einem der vorhergehenden Ansprüche,
wobei das Silbersintermittel eine Vorder- und eine Rückseite aufweist, die jeweils Silberoxidoberflächen aufweisen.

6. Verfahren nach einem der vorhergehenden Ansprüche,
wobei die Silberoxidschicht oder Silberoxidoberfläche durch Luftkontakt gebildet oder chemisch mittels Oxidationsmitteln oder durch anodische Oxidation hergestellt oder verstärkt worden ist.

7. Verwendung eines nach einem Verfahren der vorhergehenden Ansprüche hergestellten Silbersintermittels in einem Verfahren zum Verbinden von Bauelementen, bei dem man eine Anordnung aus wenigstens zwei jeweils eine metallische Kontaktoberfläche aufweisenden Bauelementen und dem zwischen den Bauelementen angeordneten Silbersintermittel bereitstellt und die Anordnung drucksintert, wobei Silberoxidoberflächen des Silbersintermittels mit den metallischen Kontaktoberflächen der Bauelemente jeweils eine gemeinsame Kontaktfläche bilden, und wobei (I) das Drucksintern in einer mindestens eine oxidierbare Verbindung enthaltenden Atmosphäre durchgeführt und/oder (II) die Silberoxidoberflächen vor Bildung der jeweiligen gemeinsamen Kontaktfläche mit mindestens einer oxidierbaren organischen Verbindung versehen werden.

8. Verwendung nach Anspruch 7,
wobei es sich bei den Bauelementen um in der Elektronik verwendete Teile handelt.

9. Verwendung nach Anspruch 7 oder 8,
wobei die Metalle der metallischen Kontaktoberfläche der zu verbindenden Bauelemente gleich oder verschieden und aus der aus Silber, Kupfer, Palladium und Legierungen dieser Metalle bestehenden Gruppe ausgewählt sind.

10. Verwendung nach einem der Ansprüche 7 bis 9,
wobei die metallische Kontaktoberfläche wenigstens eines der wenigstens zwei Bauelemente eine Metalloxidschicht aufweist.

11. Verwendung nach Anspruch 10,
wobei die Metalloxidschicht des wenigstens einen der wenigstens zwei Bauelemente vor Bildung der gemeinsamen Kontaktfläche mit mindestens einer oxidierbaren organischen Verbindung versehen wird.

12. Verwendung nach einem der Ansprüche 7 bis 11,
wobei die mindestens eine oxidierbare organische Verbindung 1 bis 50 Kohlenstoffatome aufweist und wenigstens eine funktionelle Gruppe hat.

13. Verwendung nach einem der Ansprüche 7 bis 10 oder 12,
wobei das Verhältnis der Masse der mindestens einen oxidierbaren organischen Verbindung zur Fläche der betreffenden Silberoxidschicht 0,0005 bis 10 g pro Quadratmeter Silberoxidfläche beträgt.

14. Verwendung nach einem der Ansprüche 7 bis 13,
wobei die mindestens eine oxidierbare organische Verbindung ausgewählt ist unter freien Fettsäuren, Fettsäuresalzen und Fettsäureestern.

15. Verwendung nach einem der Ansprüche 7 bis 14,
wobei die mindestens eine oxidierbare organische Verbindung aus einer wässrigen Zubereitung oder aus einer Zubereitung in organischem Lösemittel auf die Silberoxidschicht aufgebracht wird.

16. Verwendung nach Anspruch 15,
wobei es sich bei der Zubereitung um eine Lösung, Dispersion oder Suspension handelt.

## Claims

1. A method for producing a silver sintering agent in the form of a layered silver sintering body comprising silver oxide surfaces, comprising the steps of:
(1) applying a silver sintering preparation onto a support substrate comprising a surface, which is incapable of forming a sintered bond,
(2) sintering the silver sintering preparation applied in this way,
(3) detaching the layered silver sintering body formed in step (2) from the surface of the support substrate, as well as
(4) optionally producing or reinforcing a silver oxide layer on the entire or on portions of the outer surface of the layered silver sintering body as part of an oxidation step, which follows step (3).

2. The method according to claim 1,
wherein the layered silver sintering body has a layer thickness in the range of 10 to 300 µm.

3. The method according to claim 1 or 2,
wherein the support substrate comprising a surface, which is incapable of forming a sintered bond, is selected from the group consisting of aluminium oxide ceramics, nickel sheets, polyimide films, polytetrafluoroethylene films, and silicone films.

4. The method according to any one of the preceding claims,
wherein the silver sintering agent is present as endless ware.

5. The method according to any one of the preceding claims,
wherein the silver sintering agent has a front and a rear side, which each have silver oxide surfaces.

6. The method according to any one of the preceding claims,
wherein the silver oxide layer or silver oxide surface was formed by means of air contact or was produced or reinforced chemically by means of oxidising agents or by means of anodic oxidation.

7. Use of a silver sintering agent produced according to a method of the preceding claims in a method for connecting components, in the case of which an assembly of at least two components each having a metallic contact surface and the silver sintering agent arranged between the components is provided, and the assembly is pressure sintered, wherein silver oxide surfaces of the silver sintering agent each form a joint contact surface with the metallic contact surfaces of the components, and wherein (I) the pressure sintering is carried out in an atmosphere containing at least one oxidisable compound, and/or (II) the silver oxide surfaces are provided with at least one oxidisable organic compound before forming the respective joint contact surface.

8. The use according to claim 7,
wherein the components are parts used in electronics.

9. The use according to claim 7 or 8,
wherein the metals of the metallic contact surface of the components to be connected are identical or different and are selected from the group consisting of silver, copper, palladium, and alloys of said metals.

10. The use according to any one of claims 7 to 9,
wherein the metallic contact surface of at least one of the at least two components has a metal oxide layer.

11. The use according to claim 10,
wherein the metal oxide layer of the at least one of the at least two components is provided with at least one oxidisable organic compound before forming the joint contact surface.

12. The use according to any one of claims 7 to 11,
wherein the at least one oxidisable organic compound has 1 to 50 carbon atoms and has at least one functional group.

13. The use according to any one of claims 7 to 10 or 12,
wherein the ratio of the mass of the at least one oxidisable organic compound to the surface of the respective silver oxide layer is 0.0005 to 10 g per square metre of silver oxide surface.

14. The use according to any one of claims 7 to 13,
wherein the at least one oxidisable organic compound is selected from free fatty acids, fatty acid salts, and fatty acid esters.

15. The use according to any one of claims 7 to 14,
wherein the at least one oxidisable organic compound is applied to the silver oxide layer from an aqueous preparation or from a preparation in organic solvent.

16. The use according to claim 15,
wherien the preparation is a solution, dispersion, or suspension.

## Revendications

1. Procédé pour la fabrication d'un agent de frittage d'argent sous la forme d'un corps de frittage d'argent en forme de couche, avec des surfaces d'oxyde d'argent, comprenant les étapes suivantes :
(1) application d'une préparation de frittage d'argent sur un substrat de support avec une surface inapte à la formation d'une liaison de frittage,
(2) frittage de la préparation de frittage d'argent ainsi appliquée,
(3) détachement du corps de frittage d'argent en forme de couche, constitué dans l'étape (2), de la surface du substrat de support, et
(4) le cas échéant, fabrication ou renforcement d'une couche d'oxyde d'argent sur l'ensemble ou sur des parties de la surface extérieure du corps de frittage d'argent sous forme de couche au cours d'une étape d'oxydation en aval de l'étape (3).

2. Procédé conformément à la revendication 1,
le corps de frittage d'argent sous forme de couche ayant une épaisseur de couche de l'ordre de 10 à 300 µm.

3. Procédé conformément à la revendication 1 ou 2,
le substrat de support avec une surface inapte à la formation d'une liaison de frittage étant sélectionné dans le groupe composé de céramiques d'oxyde d'aluminium, de tôles de nickel, de films de polyimide, de films de polytétrafluoréthylène et de films de silicone.

4. Procédé conformément à l'une des revendications précédentes,
l'agent de frittage d'argent étant disponible en matière continue.

5. Procédé conformément à l'une des revendications précédentes,
l'agent de frittage d'argent présentant une face avant et une face arrière, lesquelles présentent respectivement des surfaces d'oxyde d'argent.

6. Procédé conformément à l'une des revendications précédentes,
la couche d'oxyde d'argent ou la surface d'oxyde d'argent ayant été formée par le contact avec l'air ou fabriquée ou renforcée chimiquement au moyen d'agents d'oxydation ou par oxydation anodique.

7. Utilisation d'un agent de frittage d'argent fabriqué selon un procédé des revendications précédentes, dans un procédé pour l'assemblage de composants, dans lequel on fournit une disposition composée d'au moins deux composants présentant respectivement une surface de contact métallique et de l'agent de frittage d'argent disposé entre les composants et on réalise un frittage sous pression de la disposition, les surfaces d'oxyde d'argent de l'agent de frittage d'argent formant, avec les surfaces de contact métalliques des composants, respectivement une surface de contact commune et (I) le frittage sous pression étant réalisé dans une atmosphère contenant au moins une liaison oxydable et/ou (II) les surfaces d'oxyde d'argent étant dotées d'au moins une liaison organique oxydable avant la formation de la surface de contact commune respective.

8. Utilisation conformément à la revendication 7,
les composants étant des pièces utilisées en électronique.

9. Utilisation conformément à la revendication 7 ou 8,
les métaux de la surface de contact métallique des composants à assembler étant identiques ou différents et sélectionnés dans le groupe composé d'argent, de cuivre, de palladium et d'alliages de ces métaux.

10. Utilisation conformément à l'une des revendications 7 à 9,
la surface de contact métallique d'au moins un des au moins deux composants présentant une couche d'oxyde de métal.

11. Utilisation conformément à la revendication 10,
la couche d'oxyde de métal d'au moins un des au moins deux composants étant dotée d'au moins une liaison organique oxydable avant la formation de la surface de contact commune.

12. Utilisation conformément à l'une des revendications 7 à 11,
au moins la liaison organique oxydable présentant 1 à 50 atomes de carbone et ayant au moins un groupe fonctionnel.

13. Utilisation conformément à l'une des revendications 7 à 10 ou 12,
le rapport entre le poids d'au moins la liaison organique oxydable et la surface de la couche d'oxyde d'argent en question étant de 0,0005 à 10 g par mètre carré de surface d'oxyde d'argent.

14. Utilisation conformément à l'une des revendications 7 à 13,
au moins la liaison organique oxydable étant sélectionnée parmi les acides gras libres, les sels d'acides gras et les esters d'acides gras.

15. Utilisation conformément à l'une des revendications 7 à 14,
au moins la liaison organique oxydable réalisée à partir d'une préparation aqueuse ou d'une préparation dans un solvant organique étant appliquée sur la couche d'oxyde d'argent.

16. Utilisation conformément à la revendication 15,
la préparation étant une solution, une dispersion ou une suspension.
